# EUROPÄISCHE PATENTSCHRIFT

(11) **EP 0 728 578 B1**
(45) Veröffentlichungstag und Bekanntmachung des Hinweises auf die Patenterteilung: **19.08.1998**
(21) Anmeldenummer: 95102103.9
(22) Anmeldetag: 15.02.1995
(51) Int. Cl.: B41C 1/14, G03F 7/12

(54) **Verfahren zur Herstellung einer Siebdruckschablone**
Process for the fabrication of screen printing master
Procédé pour la fabrication d'une matrice pour l'impression sérigraphique

(43) Veröffentlichungstag der Anmeldung: 28.08.1996
(73) Patentinhaber: Schablonentechnik Kufstein Aktiengesellschaft, 6330 Kufstein (AT)
(72) Erfinder: Fischer, Hannes, A-6300 Wörgl (AT)
(74) Vertreter: TER MEER STEINMEISTER & PARTNER GbR

(56) Entgegenhaltungen:
- EP-A- 0 329 217
- EP-A- 0 593 806
- AT-A- 304 587
- DE-A- 3 601 327
- DE-B- 1 231 258
- FR-A- 1 559 784
- NL-A- 6 608 264
- US-A- 5 338 627

## Beschreibung

Die Erfindung betrifft ein Verfahren zur Herstellung einer Siebdruckschablone gemäß dem Oberbegriff des Patentanspruchs 1. Ein derartiges Verfahren ist bereits aus der US-PS 5,338,627 bekannt. Dieses bekannte Verfahren umfaßt folgende Schritte: Aufbringen wenigstens einer lichtempfindlichen Schicht auf eine im wesentlichen geschlossene Mantelfläche eines zylindrischen Grundkörpers; bereichsweises Entfernen der lichtempfindlichen Schicht von der Mantelfläche gemäß einem vorgegebenen Siebmuster; Auffüllen der so entfernten Bereiche der lichtempfindlichen Schicht mit Metall zwecks Bildung eines Zylindersiebs: und Abnehmen des Zylindersiebs vom Grundkörper. Dabei ist hier der Grundkörper als Vollzylinder ausgebildet.

Aus der DE-A-36 01 327 ist ein Verfahren zur Herstellung einer Siebdruckschablone bekannt, bei dem eine mit einem Fotolack beschichtete Folie auf eine als Hohlzylinder ausgebildete Schablonenspannwalze aufgespannt wird, welche in Umfangsrichtung pneumatisch expandierbar ist. Entsprechend einem gewünschten Muster wird die Mantelfläche der Folie mittels eines Laserstrahls belichtet.

Bei einem aus der EP-A-0 327 217 bekannten Verfahren wird ein mit fotoempfindlichem Lack beschichtetes Rundsieb auf einen dünnwandigen, hohlen Spannzylinder aufgebracht. Dessen Innenfläche ist mit einem expandierbaren Gummischlauch und entsprechenden Füllventilen versehen. Der beschichtete Außenmantel des Rundsiebs wird mittels Laserstrahlung selektiv belichtet, wobei eine hohe Genauigkeit bei der Umdrehung des Spannzylinders eine präzise Fokussierung des Laserstrahls auf der beschichteten Oberfläche gewährleistet.

Der Erfindung liegt die Aufgabe zugrunde, das Verfahren der eingangs genannten Art so weiterzubilden, daß ein leichterer Grundkörper verwendbar ist, ohne daß dabei die Genauigkeit bei der Herstellung der Siebdruckschablone leidet, und der auch einfacher positioniert und gelagert werden kann.

Die Lösung dergestellten Aufgabe ist im kennzeichnenden Teil des Patentanspruchs 1 angegeben. Vorteilhafte Ausgestaltungen der Erfindung sind den Unteransprüchen zu entnehmen.

Das Verfahren nach der Erfindung zeichnet sich dadurch aus, daß
- als Grundkörper ein Hohlzylinder verwendet wird, und
- dieser Hohlzylinder selbst über wenigstens eine seiner Stirnseiten durch ein Druckgas so stark aufgeblasen wird, daß er einen kreisrunden Querschnitt erhält.

Untersuchungen im Zusammenhang mit dem Rundlauf dünnwandiger metallischer Zylinder haben zu dem überraschenden Ergebnis geführt. daß es trotz innerer Materialspannungen, die mehr oder weniger zufällig auftreten, möglich ist, diese Hohlzylinder durch geeigneten Innendruck so exakt kreisrund auszuformen, daß bei der Belichtung einer auf dem Hohlzylinder liegenden lichtempfindlichen Schicht z. B. mit Hilfe eines Laserstrahls der Fokus des Laserstrahls immer im Bereich der lichtempfindlichen Schicht verbleibt, wenn sich der Hohlzylinder dreht und der Laserstrahl in Längsrichtung des Hohlzylinders bewegt wird. Statische Formabweichungen des Hohlzylinders lassen sich somit weitestgehend kompensieren, so daß hervorragende Gravurergebnisse erhalten werden.

Aufgrund des im Vergleich zum Vollzylinder geringeren Gewichts des Hohlzylinders kann dieser auch einfacher positioniert bzw. gelagert werden, beispielsweise zum Aufbringen der lichtempfindlichen Schicht, zum Belichten dieser lichtempfindlichen Schicht oder zum Aufbringen des Metalls zur Bildung des Zylindersiebs, so daß er sich demzufolge auch leichter handhaben läßt und somit eine einfachere Durchführung des Verfahrens gestattet.

Wird Druckgas durch eine der Stirnseiten des Hohlzylinders in diesen hineingeblasen, so kann die andere Stirnseite des Hohlzylinders verschlossen sein. Es ist aber auch möglich, über beide Stirnseiten Druckgas in den Hohlzylinder einströmen zu lassen. Dabei wird vorzugsweise als Druckgas unter Druck stehende Luft verwendet. Diese läßt sich einem Druckleitungsnetz entnehmen oder z. B. mittels eines Axialgebläses erzeugen, das auf der Zylinderachse sitzt, wenn dieser in einer Rundlaufmaschine eingespannt ist.

Zur Belichtung der lichtempfindlichen Schicht kann, wie bereits eingangs erwähnt, ein Laserstrahl verwendet werden, der auf die lichtempfindliche Schicht auftrifft und in Längsrichtung des Hohlzylinders abgelenkt wird, wenn sich dieser um seine Achse dreht.

Dabei kann das Entfernen von Bereichen der lichtempfindlichen Schicht dadurch erfolgen, daß diese Bereiche mittels der Laserstrahlung weggebrannt werden. Hierzu wird der Laserstrahl entsprechend fokussiert. Die lichtempfindliche Schicht kann eine Einfachschicht oder Doppelschicht sein. Im zuletzt genannten Fall kann sie eine auf der Oberfläche des Grundkörpers liegende Haftverstärkungsschicht und eine auf dieser Haftverstärkungsschicht liegende eingefärbte Schicht aufweisen.

Die Schichten bestehen vorzugsweise aus:
Acrylat- und Methacrylatharzen, Epoxidharzen, ungesättigten Polyesterharzen (ungesättigt vor und während der Aufbringung), mit Styrol als Copolymerisator, Butadienharzen und Styrol als Copolymerisator, vernetzten Polyurethanharzen (insbesondere als Haftvermittlerschicht).

Während die obere Harzschicht, also die Harzdeckschicht, besonders gute Absorptionseigenschaften für die eingebrachte Laserstrahlung aufweisen soll, muß eine Haftvermittlerschicht - diese wird unmittelbar am metallischen Grundkörper aufgebracht - hohe Haftkräfte am Metallhohlzylinder aufweisen. Ganz allgemein läßt sich sagen, daß diese Haftkräfte dann höher sind, wenn die Benetzungsfähigkeit der aufgebrachten Haftvermittlerschicht im flüssigen Zustand, also vor deren Vernetzung, hoch ist. Diese Haftfähigkeit läßt sich z. B. durch oberflächenaktive Substanzen steigern, also solche, welche die Oberflächenspannung herabsetzen (z. B. Alkohole). Die Haftkraft der Lackschicht wird durch mechanische und chemisch-physikalische Wirkungen verursacht.

Die mechanische Wirkung besteht in einem Verklammerungseffekt (Druckknopfeffekt), wozu die Oberflächenrauhigkelt der Metallwand beiträgt. Bei geringerer Oberflächenspannung des noch flüssigen Haftvermittlers kann dieser besser in die Rauhigkeitstiefen eindringen. Allerdings lassen sich die Luftreste nicht ganz aus diesen Bereichen verdrängen.

Zu den chemisch-physikalischen Ursachen der Haftkraft zählen Chemosorption und Molekularkräfte (Van der Waal-Kräfte). Es ist verständlich, daß auch diese Kräfte von der Größe der tatsächlich benetzten Fläche abhängen.

Die Haftvermittlerschicht muß also vorzugsweise eine gute Benetzungsfähigkeit aufweisen. Polyurethane z. B. sind Polyadditionsprodukte aus Isocyanaten (Desmodure) und Polyestern (Desmophene). Die Isocyanate steigern besonders die chemisch-physikalischen Haftkraftkomponenten.

Die hohe Absorption der Deckschicht des Doppelschichtsystems läßt sich durch Einbringung von Farbpigmenten (z. B. Ruß) in entsprechend feiner Verteilung steigern. Die Laserstrahlung läuft sich zwischen den Farbpartikeln durch die vielmalige Reflexion tot und wird auf diese Weise in Wärmeenergie umgesetzt, die unmittelbar in der Harzschicht frei wird und so zu deren Zerstörung führt, auch wenn die Harzgrundsubstanz einen hohen Transmissionsgrad für die Laserstrahlung aufweist. Da die Schichten im allgemeinen sehr dünn sind (10 bis 20 µm), wird auch die in einer Schicht freigesetzte Wärme durch Konvektion an die andere Schicht (z. B. die Haftvermittlerschicht) weitergegeben.

Die Aufteilung in eine Doppelschicht hat auch den Vorteil, daß die obere Deckschicht auch den Beanspruchungen beim späteren Druckprozeß besser angepaßt werden kann. Es kann die Harzgrundsubstanz der Deckschicht nach ihrer Widerstandsfähigkeit gegen die mechanischen und chemischen Beanspruchungen beim Druckprozeß ausgewählt werden (z. B. steigert ein Zusatz von hochdisperser Kieselsäure deren Abrasionsfestigkeit) und die Haftvermittlerschicht kann so gewählt werden, daß deren Haftkraft zum Metallzylinder groß ist.

Es ist aber auch möglich, das Entfernen von Bereichen der lichtempfindlichen Schicht dadurch vorzunehmen, daß die lichtempfindliche Schicht durch Laserstrahlung polymerisiert und anschließend entwickelt wird. Die belichteten Bereiche härten durch Polymerisation aus und bleiben stehen, während die unbelichteten Bereiche beim Entwicklungsvorgang entfernt werden.

Nach einer vorteilhaften Ausgestaltung der Erfindung wird eine polymerisationsfähige lichtempfindliche Schicht verwendet, die wenigstens eine eingefärbte erste Harzschicht auf der Oberfläche des Hohlzylinders und eine zweite transparente und photosensibilisierte Harzschicht auf der ersten Harzschicht aufweist.

Die erste Harzschicht ist mit einem die Lichtenergie dissipativ absorbierenden Farbstoff eingefärbt und entweder gar nicht oder nur schwach sensibilisiert. Über dieser ersten Harzschicht kommt die dünne und vorzugsweise stark transparente zweite Harzschicht zu liegen, die einen hohen Anteil eines Photosensibilisators aufweist. Im Anschluß hieran wird der beschichtete Hohlzylinder durch Strahlung jener Wellenlänge musterkonform belichtet, auf welche der Photosensibilisator anspricht. Diese Wellenlänge liegt z. B. im Bereich von 380 nm bis etwa 532 nm und läßt sich durch einen geeigneten Laser zur Verfügung stellen. Beide Harzschichten weisen im Mittel jeweils eine Dicke von etwa 5 µm bis 10 µm auf.

Der Vorteil dieser Technik besteht darin, daß sich unerwünschte Polymerisationserscheinungen verhindern lassen, und zwar in Harzbereichen, die erst durch Licht belichtet werden, das an Unregelmäßigkeiten der Oberfläche des Hohlzylinders reflektiert bzw. gestreut wird. Das Harzsystem läßt sich somit einerseits feiner strukturieren, und zwar bei relativ großer Schichtdicke, wodurch andererseits auch Ablösungserscheinungen beim anschließenden Entwicklungsprozeß unterbunden werden.

Die Schichten setzen sich aus dem Basisharzsystem, Fotoinitiator und einem Pigmentfarbstoff zusammen:
Das Basisharzsystem besteht aus einer der folgenden Komponenten oder aus einem Copolymerisat dieser:
Hydroxymethylacrylat
aromatisches Acrylat
Methylmethacrylat
Polyepoxid

Als Foto-Sensibilisator oder -Initiator wird verwendet:
Ein Titanocen
   (z. B. Titanocendichlorid, µ-Chlorbis-µ-Methylentitan, Methyltristitan)
N-Vinylpyrrolidone
Ferrocen
oder Mischungen dieser Komponenten.

Bei den Farbstoffen handelt es sich um ein an sich bekanntes Farbpigment, wobei es nur darauf ankommt, daß diese Pigmente in der Harzsubstanz in sehr feiner Verteilung (ca. 1 µm Partikelgröße) mit Harzkanälen zwischen den Pigmenten vorliegen. Durch diese Anordnung wird beijeder Lichtreflexion ein Teil der Lichtenergie dissipativ absorbiert, d. h. letztlich in Wärme umgesetzt. Die dadurch bedingte Temperatursteigerung ist aber zu gering, um einen thermisch induzierten Vernetzungsvorgang einzuleiten.

Vorzugsweise kann die erste Harzschicht noch eine Substanz enthalten, durch die bei Belichtung freigesetzte Radikale abgefangen werden, um in noch größerem Ausmaß ungewünschte Verbreiterungen der Konturen zu verhindern, wenn diese Radikale nicht durch den Polymerisationsvorgang selbst verbraucht werden.

Nach einer sehr vorteilhaften Weiterbildung der Erfindung kann die Belichtung der lichtempfindlichen Schicht so erfolgen, daß spätere Sieböffnungen unterschiedliche Abstände voneinander aufweisen.

Als Vorteil ergibt sich bei einer Matrizengravur, also bei einer Gravur des aus Hohlzylinder und lichtempfindlicher Schicht bestehenden Systems, die Möglichkeit, unterschiedliche Abstände der Sieböffnungen bei der Halbtontechnik zu realisieren. Halbtöne - also unterschiedliche Farbintensitäten bei der Verwendung einer Druckform, also beim Drucken - können grundsätzlich auf zwei verschiedene Weisen erzeugt werden.

Zunächst besteht die Möglichkeit, die Sieböffnungen verschieden groß auszuführen. Dies ist dann die einzige Möglichkeit, wenn das Sieb bereits vorgefertigt ist und im wesentlichen gleichgroße Sieböffnungen vorliegen und diese auch stets die gleichen Abstände aufweisen. Das Sieb wird dann mit Lack verschlossen und dieser Lack unterschiedlich abgetragen. Man legt hier einmal eine Gruppe von Sieböffnungen z. B. durch einen Laser frei und läßt andere Gruppen von Sieböffnungen verschlossen.

Eine andere Möglichkeit besteht darin, gleichgroße Sieböffnungen in unterschiedlichen Abständen anzuordnen. Man wählt dann diese Abstände größer, wenn weniger Farbe auf das zu bedruckende Substrat gelangen soll und umgekehrt.

Während die zuerst genannte Methode zu ungleichmäßigen bzw. von Störungen überlagerten Mustern führt, also zu einer Art Farbmoire, werden bei der in der vorliegenden Erfindung angewandten zweiten Methode die Öffnungsabstände des Siebs variiert, so daß die aus Farbüberlagerungen entstehende Mischfarbenbildung sehr viel gleichmäßiger wird.

Nach einer anderen vorteilhaften Weiterbildung der Erfindung wird beim Auffüllen der entfernten Bereiche der lichtempfindlichen Schicht mit Metall der Grundkörper von innen verstärkt. Diese Verstärkung kann z. B. durch Einbringen eines Schlauchs in den Grundkörper erfolgen, wobei der Schlauch, der z. B. aus Gummi bestehen kann, an der Innenwand des Grundkörpers anliegt. Dadurch wird der Grundkörper bzw. Hohlzylinder nicht nur weitgehend ausgerundet sondern bleibt auch trotz der mechanischen Beanspruchung beim Aufbringen des Metalls weitgehend formstabil. Der Schlauch kann auch aufgeblasen werden, was zu eine noch bessere Verstärkung bzw. Versteifung führt.

Als Metall kann z. B. Nickel galvanotechnisch aufgebracht werden. Durch die Innenverstärkung des Hohlzylinders können dann z. B. Auftriebskräfte des elektrolytischen Bads weitgehend kompensiert werden.

Die Verwendung eines Hohlzylinders als Grundkörper hat darüber hinaus auch den Vorteil, daß sich das auf ihm gebildete Zylindersieb leichter abnehmen läßt. Hierzu wird lediglich das Zylindersieb mittels eines geeigneten und abgerundeten Gegenstands radial nach innen gedrückt, so daß an der entsprechenden Stelle eine Delle entsteht und damit eine örtliche Schubspannung, welche die Haftkräfte zwischen dem metallischen Sieb und dem Grundkörper bzw. Hohlzylinder bricht.

Die Erfindung wird nachfolgend unter Bezugnahme auf die Zeichnung im einzelnen beschrieben. Es zeigen:
**Figur 1** einen Verfahrensschritt zum Aufsprühen einer lichtempfindlichen Schicht auf die nicht unterbrochene Mantelfläche eins hohlzylindrischen Grundkörpers;
**Figur 2** einen weiteren Verfahrensschritt zum Aufbringen einer lichtempfindlichen Schicht aufdie nicht unterbrochene Mantelfläche eines hohlzylindrischen Grundkörpers;
**Figur 3** einen Längsschnitt durch einen hohlzylindrischen Grundkörper mit nicht unterbrochener Mantelfläche und darauf liegender lichtempfindlicher Schicht;
**Figur 4** einen Längsschnitt gemäß Figur 3 mit belichteter und stellenweise polymerisierter lichtempfindlicher Schicht;
**Figur 5** die Struktur gemäß Figur 4 nach durchgeführter Entwicklung;
**Figur 6** einen Längsschnitt gemäß Figur 3 mit Bereichen der lichtempfindlichen Schicht, die dadurch erhalten wurden, daß die daneben liegenden Bereiche der lichtempfindlichen Schicht durch thermische oder lithographische Ablation beseitigt wurden;
**Figur 7** die Struktur nach Figur 5 oder 6 mit galvanisch aufgebrachter Metallschicht;
**Figur 8** eine Vorrichtung zum Belichten einer aus Hohlzylinder und lichtempfindlicher Schicht bestehenden Matrize;
**Figur 9** einen Verfahrensschritt zum Aufbringen einer Metallschicht auf die Matrize;
**Figur 10** einen Verfahrensschritt zum Ablösen einer siebförmigen Metallschicht von der Matrize; und
**Figur 11** einen Ausschnitt aus Figur 10 zur Erläuterung einer Kräfteverteilung im eingedellten Bereich.

Im Falle der vorliegenden Erfindung wird zunächst ein dünnwandiger Hohlzylinder mit einer oder mehreren lichtempfindlichen Lackschichten ausgerüstet. Der Hohlzylinder besteht aus einem dünnen Metallblech mit durchgehender Mantelfläche. Seine Wandstärke liegt etwa im Bereich von 0,1 bis 0,3 mm. Es kann sich hierbei um einen Hohlzylinder von mehreren Metern Länge und mehreren 10 cm im Durchmesser handeln.

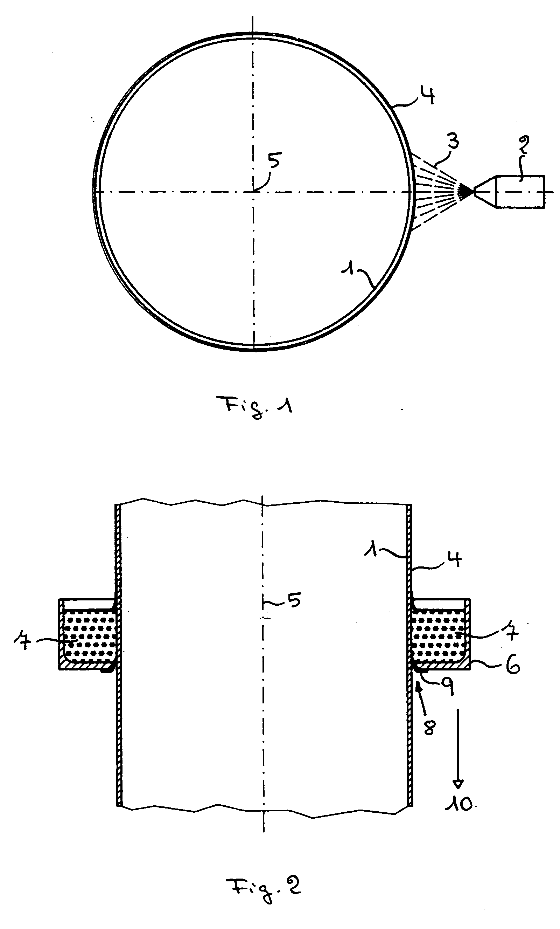

Entsprechend der Figur 1 kann das Beschichten eines Hohlzylinders 1 mittels einer Sprühdüse 2 erfolgen. Dabei wird Lack zunächst nach dem Austreten aus der Sprühdüse 2 so fein versprüht, daß ein Nebel 3 entsteht, der sich dann auf die äußere Mantelfläche des Hohlzylinders 1 niederschlägt, um dort einen dünnen Lackfilm 4 zu bilden. Während dieses Prozesses kann sich der Hohlzylinder 1 um seine Längsachse 5 drehen und die Sprühdüse 2 wird mit langsamer Geschwindigkeit parallel zur Längsachse 5 bewegt.

Die Figur 2 zeigt einen Fall, bei dem der Hohlzylinder 1 unter Verwendung einer Ringwanne 6 mit Lack beschichtet wird. In der Ringwanne 6 befindet sich eine Lackemulsion 7. Die Ringwanne 6 ist bei 8 durch eine Dichtlippe 9 so abgedichtet, daß keine Lackemulsion 7 nach unten austreten kann. Die Ringwanne 6 wird langsam nach unten in Richtung des Pfeils 10 abgesenkt. Hierdurch bildet sich auf der Oberfläche des Hohlzylinders 1 ein dünner Lackfilm 4 aus, der umso dünner ausfällt, je langsamer die nach unten gerichtete Absenkbewegung der Ringwanne 6 ist.

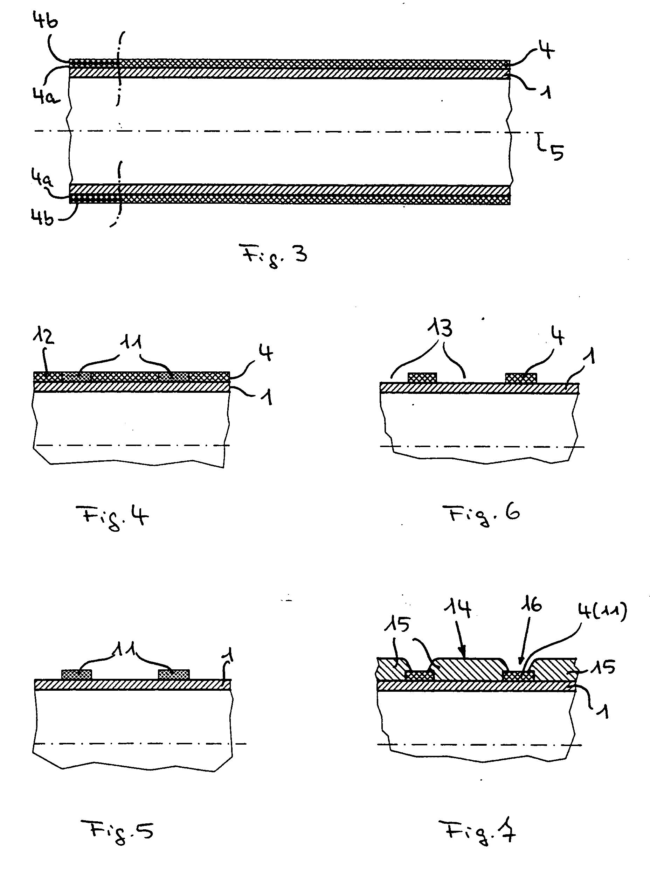

Die Figur 3 zeigt das Ergebnis dieses Beschichtungsvorgangs in größenordnungsmäßig verzerrter Darstellung. Der Hohlzylinder 1 trägt hier auf seiner äußeren Manteloberfläche die Lackschicht 4. Ihre Schichtdicke ist gegenüber dem Durchmesser des Hohlzylinders 1 bzw. dessen Wandstärke erheblich dicker dargestellt.

Die Figur 4 zeigt einen Ausschnitt von Figur 3, wobei die Lackschicht 4 lichtempfindlich im Sinne einer Polymerisationsfähigkeit durch Licht ist, und zwar nach einer den Mustererfordernissen entsprechenden Belichtung. Genauer gesagt wurden Bereiche 11 der Lackschicht 4 belichtet und erfuhren hierdurch eine strukturelle Veränderung. Im allgemeinen werden bei der Belichtung in der Lackschicht 4 bestehende Doppelbindungen aufgebrochen und diese reagieren mit benachbarten Kettenmolekülen des Lackes bzw. des Harzes, weil in diesem gleichartig aufgebrochene Doppelbindungen vorhanden waren. Es kommt zu einer Quervernetzung (cross-linking) und damit zu einer Härtung. Auch wird durch die Vernetzung eine höhere chemische Beständigkeit erreicht. Letztere wird dazu benutzt, um in einem nachfolgenden Entwicklungsvorgang die nicht belichteten und daher weniger beständigen Harzbereiche aus der Lackschicht 4 herauszulösen.

Zu diesem Zweck kann der gesamte Hohlzylinder mit darauf liegender und belichteter Lackschicht 4 in ein Entwicklermedium getaucht werden, welches sich in einer Wanne befindet, und es werden dadurch die nicht durch die Lichteinwirkung vernetzten Stellen 12 der Lackschicht 4 herausgelöst. Zweckmäßigerweise kann die Entwicklerflüssigkeit aus einer alkalischen Lösung (Soda, Kalilauge, Natronlauge) bestehen. Zur Unterstützung des Entwicklungsvorgangs kann unverbrauchte Entwicklerlösung aus einer Brause auf die Oberfläche der zu entwickelnden Lackschicht 4 aufgesprüht werden. Der Hohlzylinder 1 mit darauf liegender Lackschicht 4 läuft während des Entwicklungsvorgangs um seine Längsachse 5 um und taucht abschnittsweise in die Entwicklerflüssigkeit ein.

Das Ergebnis ist in Figur 5 dargestellt. Nach dem Entwicklungsvorgang verbleiben die vernetzten Bereiche 11 der Lackschicht 4 auf der Oberfläche des Hohlzylinders 1.

Nach einer Variante des Verfahrens kann anstelle einer einfachen Lackschicht 4 auch eine doppelte Lackschicht verwendet werden. In diesem Fall kommt unmittelbar auf der äußeren Mantelfläche des Hohlzylinders 1 eine stärker lichtabsorbierende Schicht 4a zu liegen. Ihre starke Lichtabsorption kann durch Zugabe höherer Dosen eines lichtabsorbierenden Farbstoffs zur Harzgrundmasse herbeigeführt werden. Auf diese Schicht 4a wird eine weitere Schicht 4b aufgebracht, die weitgehend transparent gehalten wird und die im allgemeinen auch eine höhere Dosis eines Sensibilisators enthält. Natürlich ist eine vollständige Transparenz dieser zweiten Schicht 4b nicht möglich, weil eine Bestrahlung, die eine Vernetzung bewirken soll, ein Einfangen von Lichtquanten durch das Harz zur Bedingung hat. Durch diesen Einfangvorgang werden gerade jene photochemischen Vorgänge in Gang gesetzt, die letztendlich zur Vernetzung fuhren. Die Doppelschichttechnik unter Aufbringen der Schichten 4a und 4b ist insbesondere dann von Vorteil, wenn feine und scharfe Konturen erzeugt werden sollen. Durch die unterlagerte Farbstoffschicht 4a wird der zur Konturenverbreiterung führende diffuse Lichtstreueffekt durch die metallische und meist auch leicht zerkratzte Oberfläche des Hohlzylinders 1 unterbunden. Die bei dieser Verfahrensvariante erforderlichen zwei verschiedenen Schichten 4a und 4 b werden nacheinander mit einem der in Figur 1 oder Figur 2 beschriebenen Verfahren aufgebracht, wobei jeweils nach Aufbringen einer der Schichten die jeweilige Schicht getrocknet wird. Das Belichten der polymerisationsfähigen Schichten kann mit Hilfe eines Laserstrahls erfolgen, dessen Wellenlänge z. B. im Bereich von 320 nm bis 550 nm liegt. Hierauf wird weiter unten näher eingegangen.

Wie in Figur 6 gezeigt ist, kann der Belichtungsvorgang aber auch so durchgeführt werden, daß durch thermische oder lithographische Ablation belichtete Stellen 13 der Lackschicht 4 unmittelbar abgetragen bzw. weggebrannt werden. Hierfür ist im allgemeinen eine höhere Strahlungsleistung des Lasers erforderlich, jedoch entfällt dafür der stärker umweltbelastende chemische Entwicklungsprozeß.

In einem weiteren Verfahrensschritt erfolgt nun eine thermische Nachhärtung der auf dem Hohlzylinder verbliebenen Bereiche der Harzschicht 4. Es kann sich also hier um die Bereiche gemäß Figur 5 oder Figur 6 handeln. Durch ein Einbrennen oder Tempern bei Temperaturen von etwa 140 bis 160 °C werden alle noch in den auf dem Hohlzylinder 1 verbliebenen Harzbereichen vorhandenen Doppelbindungen quervernetzt und damit ein besonders gutes Verhalten im nächsten Prozeßschritt bewirkt.

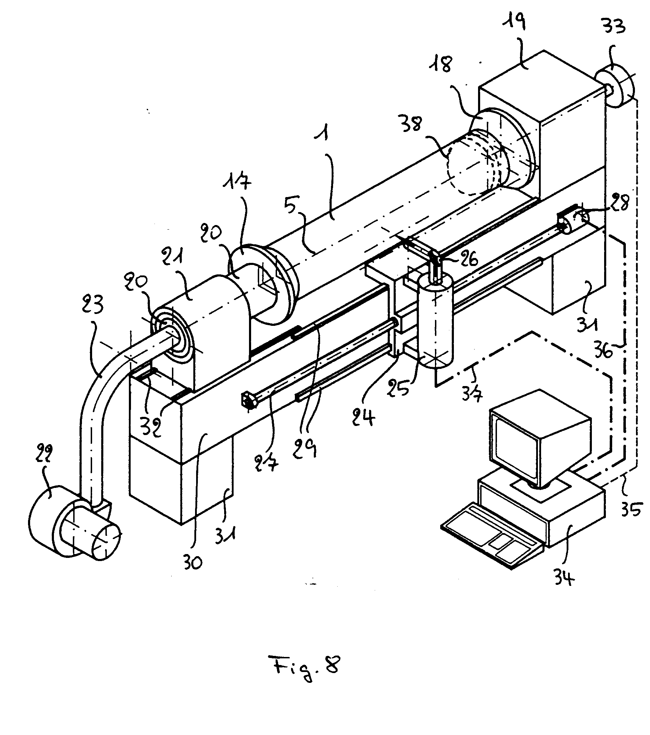

Dieser Schritt ist in Figur 7 schematisch dargestellt. Es kann sich hierbei um einen Aufnickelungsvorgang in einem galvanischen, manchmal auch chemischen Nickelbad handeln. Nickel wird jetzt auf die metallisch blanken Stellen des Hohlzylinders 1 zwischen den vernetzten Bereichen der Lackschicht 4 abgelagert. Auf diese Weise bildet sich ein Nickelsieb 14 aus, das Stege 15 und Sieböffnungen 16 aufweist.

Durch das Einbrennen oder Nachtempern sind die verbliebenen Bereiche der Lackschicht 4 sehr chemikalienfest geworden und dadurch auch weniger anfällig für ein Aufquellen in der Badflüssigkeit. Insbesondere bei einem galvanischen Aufnickelungsvorgang kann es bei nicht ausreichend chemikalienfesten Schichten zu einem Quellen der Lackschicht kommen und in weiterer Folge zu einem Durchschlag des Stroms durch die verbliebenen Lackschichtbereiche hindurch. Es würden dort Nickelperlen aufwachsen, die sich schließlich mit den Stegen 15 verbinden und die Sieböffnungen 16 verschließen würden.

Nach Ausbildung des Nickelsiebs 14 auf dem Hohlzylinder 1 gemäß Figur 7 wird dieses vom Hohlzylinder 1 abgenommen, wie noch erläutert wird. Das abgenommene Nickelsieb 14 kann dann als Siebdruckschablone verwendet werden, beispielsweise zum Bedrucken von Textilien, und dergleichen. Sofern es sich um ein gleichmäßig perforiertes Nickelsieb 14 handelt, kann dieses erneut mit Lack beschichtet und danach belichtet werden, um musterbedingt wieder Öffnungen des Siebs 14 freizulegen.

Im nachfolgenden wird unter Bezugnahme auf die Figur 8 beschrieben, wie der mit der lichtempfindlichen Schicht 4 versehene Hohlzylinder 1 behandelt wird, um die in den Figuren 5 oder 6 gezeigten Strukturen zu erhalten.

Zu diesem Zweck wird der mit der lichtempfindlichen Lackschicht 4 versehene Hohlzylinder 1 an seinen beiden Stirnseiten in einer Rund-Graviermaschine durch zwei kegelstumpfförmige Endzapfen gelagert und durch einen Laserstrahl wird der lichtempfindliche Lack so mit einem Musterbild versehen, daß die in den Figuren 5 oder 6 gezeigten Strukturen entstehen.

Soll die Lackschicht 4 mit Hilfe des Laserstrahls weggebrannt werden, so kann hierfür ein CO₂-Gaslaser mit einer Wellenlänge von 10,6 µm verwendet werden. Für den bereits erwähnten Vernetzungsvorgang kommt dagegen ein Laser mit einer Wellenlänge im Bereich von 320 nm bis 550 nm zum Einsatz.

Außerdem wird der Hohlzylinder 1 durch Einblasen von Luft oder eines anderen geeigneten Arbeitsgases in seiner Querschnittsform kreisförmig ausgerundet und während des gesamten Belichtungs- bzw. Gravurvorgangs durch Konstanthalten des Gasdrucks in seinem Innern stets in einer möglichst gleichartigen kreisrunden Form gehalten.

Die Figur 8 zeigt die Gesamtansicht einer Vorrichtung zur Belichtung des Hohlzylinders. Der Hohlzylinder trägt wiederum das Bezugszeichen 1 und auf seiner Oberfläche die nicht näher dargestellte Lackschicht 4, wie bereits unter Figur 3 erwähnt. Beim Hohlzylinder 1 handelt es sich um einen dünnwandigen Metallzylinder mit vollständig geschlossener Mantelfläche. Auf eventuell vorhandene und herstellungsbedingte wenige Poren in diesem Zylinder soll nicht eingegangen werden.

Der Hohlzylinder 1 ist an seinen beiden offenen Enden abgestützt, und zwar greift an seinem reitstockseitigen Ende ein Stützkegel 17 und an seinem spindelstockseitigen Ende ein Stützkegel 18 in ihn ein. In einem Spindelstock 19 ist ein Drehantrieb für die Einleitung einer Drehbewegung in den Hohlzylinder 1 vorgesehen. Durch den spindelstockseitigen Stützkegel 18 wird darüber hinaus des entsprechende Ende des Hohlzylinders 1 weitestgehend luftdicht verschlossen. Über eine Hohlwelle 20 im Reitstock 21 wird Luft in das Innere des Hohlzylinders 1 eingeleitet, deren Druck in geeigneter Weise gegenüber dem Umgebungsdruck etwas erhöht wurde. Für die Aufbringung dieser Luft ist z. B. ein Radialgebläse 22 vorgesehen, welches über eine Luftleitung 23 die komprimierte Luft zur Hohlwelle 20 führt.

Ein Schlitten 24 wird in Richtung der Längsachse 5 des Hohlzylinders 1 bewegt, während sich der Hohlzylinder 1 dreht. Auf dem Schlitten 24 ist ein mitlaufender Festkörper-Laser 25 vorgesehen, der im Takt der Musterinformation ein- bzw. ausgeschaltet wird. Dabei wird der Laserstrahl des Lasers 25 über einen ebenfalls am Schlitten 24 montierten Umlenkspiegel 26 so umgelenkt, daß er radial auf die Oberfläche des Hohlzylinders 1 auftrifft. Der Schlitten 24 wird durch eine Spindel 27 mit angeflanschtem Schrittmotor 28 angetrieben. Führungen 29 sind für die genaue Parallelführung des Schlittens 24 verantwortlich. Diese Führungen 29 sind fest an einem Maschinenbett 30 angebracht und verlaufen parallel zur Achsrichtung 5 des Hohlzylinders 1. Das auf Füßen 31 stehende Maschinenbett 30 trägt sowohl den Reitstock 21 als auch den Spindelstock 19, wobei der Reitstock 21 in Längsrichtung des Hohlzylinders 1 verschoben werden kann. Hierzu ist der Reitstock 21 auf Führungen 32 angeordnet, die auf dem Maschinenbett 30 befestigt sind. Auf diese Weise kann die Lage des Reitstocks 21 unterschiedlichen Längen des Hohlzylinders 1 angepaßt werden und außerdem kann der Reitstock 21 zum Auswechseln des Hohlzylinders 1 von diesem abgerückt werden, so daß der Hohlzylinder 1 auf einfache Weise nach rückwärts aus der Maschine entnommen werden kann.

Ein Drehwinkelgeber 33 (Encoder) gibt die jeweilige Winkellage des Hohlzylinders 1 an einen Rechner 34 über eine Datenleitung 35. Der Rechner 34 übermittelt über eine nicht mehr gezeigte Steuereinheit die Schrittimpulse an den Schrittmotor 28 über eine Leitung 36 und die Ein- und Ausschaltbefehle an den Festkörper-Laser 25 über eine Leitung 37.

Wird der Hohlzylinder 1 in der Vorrichtung nach Figur 8 eingespannt, so wirkt ein Biegemoment auf das Maschinenbett 30, welches sich als Produkt der auf Reit- bzw. Spindelstock einwirkenden gesamten Druckkraft und dem Abstand zwischen der Drehachse 5 des Hohlzylinders 1 und der Schwerachse des Querschnitts des Maschinenbetts 30 ergibt. Dieses Biegemoment bewirkt, daß sich das Maschinenbett 30 im Bereich zwischen Spindelstock 19 und Reitstock 21 nach oben in Richtung zum Hohlzylinder 1 krümmt. Zwar sind diese Deformationen verglichen mit den Gesamtabmessungen der Gravurvorrichtung nur sehr gering, aber die am Maschinenbett 30 vorgesehenen Führungen 29 für den Gravurschlitten 24 werden relativ zur Drehachse 5 des Hohlzylinders 1 und damit zu den Mantelerzeugenden des Hohlzylinders 1 in einem besonders bei feinen Gravurarbeiten häufig doch bemerkbaren Ausmaß gekrümmt.

Um diesem Effekt zu begegnen, wird nun der Hohlzylinder 1 in seinem Innern mit einem in axialer Richtung verlagerbaren Dichtkolben 38 ausgerüstet. Dieser Ausrüstung des Hohlzylinders 1 mit einem an seiner Innenwandung abdichtenden Dichtkolben 38, der mittels eines strangförmigen Elements, hier eines Seils, die von ihm aufgenommene Druckkraft auf den Reitstock 21 überträgt, bewirkt, daß kein Biegemoment mehr auf das Maschinenbett 30 einwirkt. Die Kraft im strangförmigen Element, hier die Seilkraft, wirkt auf den Reitstock 21 als Zugkraft und ist gleichgroß und entgegengesetzt gerichtet wie die Summe aller Druckkräfte, die auf den Reitstock 21 wirken. Wesentlich hierfür ist, daß über das strangförmige Element bzw. das Seil keine Querkraft auf den Reitstock 21 übertragen wird. Zu diesem Zweck kann das strangförmige Element bzw. Seil wenigstens annähernd in Richtung und Lage der Drehachse 5 des Hohlzylinders 1 verlaufen, um dann ggf. um eine erste Umlenkrolle und eine zweite Umlenkrolle herumgeführt und z. B. auf eine Seiltrommel aufgewickelt oder von dieser abgewickelt zu werden. Natürlich kann der Verlauf des strangförmigen Elements auch etwas von der Lage der Drehachse 5 abweichen, wobei dieses von der Ausführung und der Steifigkeit des Maschinenbetts 30 abhängt, da Krümmungen des Maschinenbetts 30, erst wenn diese ein bestimmtes Grenzmaß überstiegen, im Gravurbild bemerkbar sind. Der Dichtkolben 38 wird möglichst bis nahe zum Stützkegel 18 gefahren, ohne diesen jedoch zu berühren. Für die Bewegung des Dichtkolbens 38 in dieser Richtung wird die in den Zylinder 1 eingeblasene Luft verwendet. Nach Ende der Gravurarbeit läßt sich der Dichtkolben 38 mit Hilfe des strangförmigen Elements bzw. Seils in Richtung zum Stützkegel 17 ziehen und auf diesen aufsetzen, so daß der Hohlzylinder 1 aus der Gravurmaschine herausgenommen werden kann, ohne daß der Dichtkolben 38 vom Stützkegel 17 abfällt.

Der Dichtkolben 38 kann z. B. auf einem zentralen Zuganker über Kugellager gelagert sein, so daß er mit dem Hohlzylinder 1 um den Zuganker herumlaufen kann, wenn sich der Hohlzylinder 1 dreht. Der Zuganker ist dann mit dem strangförmigen Element bzw. Seil gekoppelt und nimmt den Dichtkegel 38 in Axialrichtung des Hohlzylinders 1 mit.

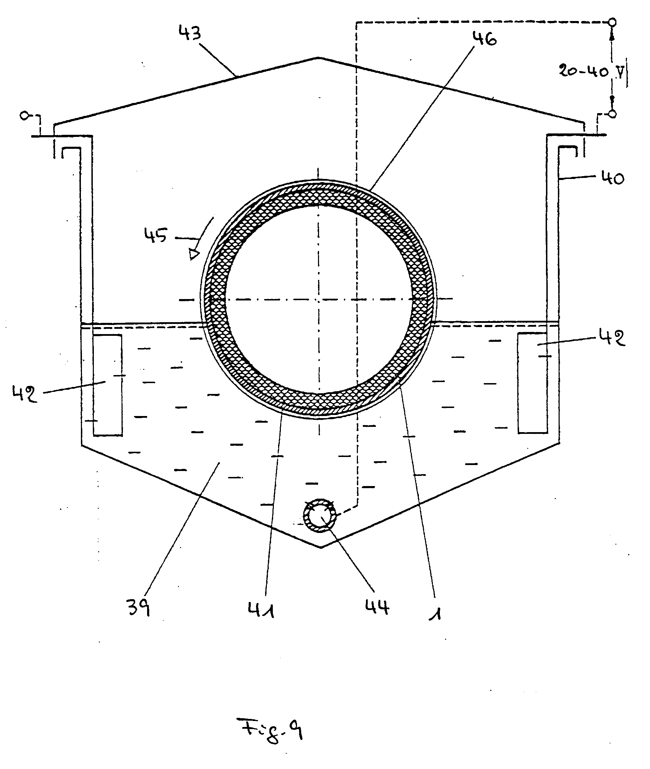

Nach Beenden des Gravurvorgangs mit Hilfe der in Figur 8 gezeigten Vorrichtung erfolgt der bereits erwähnte Entwicklungsschritt, um die in den Figuren 5 und 6 gezeigten Strukturen zu erhalten. Danach erfolgt die Bildung des Siebs und das Abnehmen des Siebs vom Hohlzylinder gemäß den Figuren 9 bis 11.

Nach der Belichtung und Entwicklung der lichtempfindlichen Lackschicht 4 (Photolackschicht) auf dem Hohlzylinder 1 liegt nunmehr auf der Oberfläche des Hohlzylinders 1 ein Musterbild in Form von kleinen Lackpunkten vor. Dieser Lack ist wasser- und einigermaßen chemikalienbeständig, so daß der Lack den nachfolgenden Verfahrensschritt übersteht, bei welchem in einem mäßig sauren Ni-Chlorid bzw. Ni-Sulfat-Elektrolyt Reinnickel auf der Oberfläche galvanisch aufgebracht wird. Die Lackpunkte dürfen sich hierbei auch nicht von der Oberfläche des Hohlzylinders 1 ablösen. Der pH-Wert des Elektrolyten liegt hierbei bei pH = 3 bis 4, die Temperaturzwischen 40 und 60 °C. Der Lack ist ein Kunstharz, meist ein Acrylat, und muß natürlich auch bei Einwirkung des Elektrolyten isolierend bleiben.

Der Vorgang des Aufnickelns im Galvanobad ist in Figur 9 dargestellt. Es bezeichnet 1 wiederum den dünnwandigen Hohlzylinder, der teilweise in einen Elektrolyten 39 eingetaucht ist. Dieser Elektrolyt 39 befindet sich in einer Wanne 40 aus isolierendem Kunststoff. Im Innern des Hohlzylinders 1 ist ein Gummischlauch 41 vorgesehen mit einer Wandstärke von ca. 3 bis 4 mm, der mit Druckluft (1 bis 2 bar) gefüllt ist. Dadurch wird der Hohlzylinder 1 nicht nur weitgehend ausgerundet sondern bleibt auch trotz der Beanspruchung durch die Auftriebskräfte des elektrolytischen Bads weitgehend formstabil. Der Hohlzylinder 1 hat zumeist Abmessungen von etwa 200 bis 350 mm Durchmesser und weist eine Länge von ca. 2000 bis 4000 mm auf. Man wählt die Eintauchtiefe in den Elektrolyten stets so, daß die Durchbiegung des Hohlzylinders 1 einige Zehntel Millimeter nicht übersteigt. Anodenkörbe 42 werden an eine Gleichspannung von +20 bis +40 V gelegt, während der Hohlzylinder 1 über nicht mehr dargestellte Schleifringkontakte auf Nullpotential liegt. In den Anodenkörben 42 befinden sich Nickel-Squares, die dank der angelegten Spannung in dem Elektrolyten gelöst werden, während sich zur gleichen Zeit Nickel auf der kathodisch geschalteten Hohlzylinderoberfläche niederschlägt. Die gesamte Einrichtung ist durch einen Deckel 43 während des Aufnickelungsvorgangs abgedeckt, damit nicht Staub in das Bad gelangt und gesundheitsschädliche Dämpfe nicht entweichen können. Damit der Elektrolyt 39 immer gleichmäßige Konzentration aufweist und auch allfällig sich bildende Wasserstoffbläschen nicht auf der Oberfläche des Hohlzylinders 1 haften bleiben, bläst man am Boden der Wanne 40 Luft über eine Leitung 44 ein. Außerdem wird der Hohlzylinder 1 in Richtung des Pfeils 45 gedreht, damit sich auf dessen Oberfläche ein gleichmäßig dünner Film aus Reinnickel bildet, und zwar dort, wo die Oberfläche des Hohlzylinders 1 nicht durch Lack abgedeckt ist. An den mit Lack abgedeckten Stellen bleiben kleine Sieböffnungen bestehen, weil ja der Lack in Form von kleinen isolierenden Punkten während der vorhergehenden Verfahrensschritte aufgebracht wurde. Wenn ein Reinnickelfilm 46 etwa 0,1 mm dick aufgewachsen ist, wird der Hohlzylinder 1 aus dem Bad herausgehoben.

Besteht der Hohlzylinder 1 oder zumindest dessen äußere Manteloberfläche aus Nickel, so befand sich auf der Oberfläche des Hohlzylinders 1 schon vor dessen Einbringen in das Bad eine sehr dünne, die elektrische Leitfähigkeit praktisch nicht beeinträchtigende Schicht aus Nickeloxid, die aus Gründen der Sicherheit durch kurzes Übergießen mit Chromsäure noch verstärkt wurde. Diese Nickeloxidschicht, die an der Luft befindliches Nickel stets aufweist, hat den Effekt, daß die Haftung des aufgebrachten Reinnickelfilms 46 durch affine Kräfte stark vermindert ist. Eine Resthaftung ist aber noch vorhanden und muß auch vorhanden bleiben, weil ansonsten dieser Reinnickelfilm 46 im Bad durch Biegebeanspruchung des Hohlzylinders 1 auf der Seite seiner Biegedruckbeanspruchung, das ist die ins Bad eintauchende untere Hälfte des Hohlzylinders, faltig und damit unbrauchbar würde.

Durch Zusatzstoffe und die Art der Badführung (Temperatur und spezifische Strombelastung) hat man allerdings zusätzlich die Möglichkeit, im aufgebrachten Reinnickelfilm 46 Druckspannungen aufzubauen. Trotzdem müssen die wenn auch nur geringen Haftkräfte dieses Films von der aus Nickeloxid bestehenden Oberfläche des Hohlzylinders 1 gelöst werden. Dies bewirkt man am besten durch das Freisetzen von Schubspannungen zwischen der Nickeloxidschicht und dem Reinnickelfilm 46.

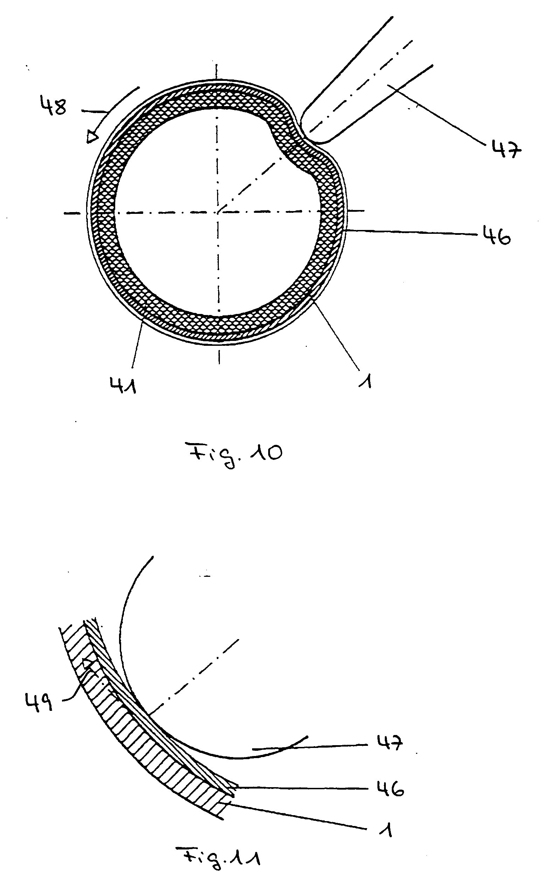

Wie in den Figuren 10 und 11 gezeigt, wird zu diesem Zweck der aus dem Bad herausgenommene Hohlzylinder 1 mit dem darüber befindlichen Reinnickelfilm 46 durch Einwirken eines stumpfen, abgerundeten Gegenstands 47 deformiert. Der Gegenstand 47 drückt hier radial zum Zentrum des Hohlzylinders 1, in dessen Innern sich noch der Schlauch 41 befinden kann. Auch während dieses Arbeitsvorgangs rotiert der Hohlzylinder 1 in Richtung des Pfeils 48. Hierdurch dellt sich der Hohlzylinder 1 und mit ihm der Reinnickelfilm 46 leicht ein und es entsteht an der Druckstelle eine Delle, durch die eine örtliche Schubspannung 49 erhalten wird, wie in Figur 11 dargestellt. Diese Schubspannung hebt Praktisch die Haftkräfte zwischen der Nickeloxidschicht und dem Reinnickelfilm 46 auf. In Figur 11 ist der Schlauch 41 der Übersicht wegen nicht dargestellt. Durch geringe innerhalb des Reinnickelfilms 46 während des Aufnickelungsvorgangs aufbebaute Druckspannungen wird der Durchmesser des Reinnickelfilms 46 geringfügig größer und die aus dem Reinnickelfilm 46 bestehende, gemusterte Siebhülse 14 (siehe Figur 7) kann anschließend vom Zylinder 1 abgezogen werden.

## Patentansprüche

1. Verfahren zur Herstellung einer Siebdruckschablone, mit folgenden Schritten:
- Aufbringen wenigstens einer lichtempfindlichen Schicht (4; 4a, 4b) auf eine im wesentlichen geschlossene Mantelfläche eines zylindrischen Grundkörpers (1);
- bereichsweises Entfernen der lichtempfindlichen Schicht (4; 4a, 4b) von der Mantelfläche gemäß einem vorgegebenen Siebmuster; - Auffüllen der so entfernten Bereiche der lichtempfindlichen Schicht (4; 4a, 4b) mit Metall zwecks Bildung eines Zylindersiebs (14); und
- Abnehmen des Zylindersiebs vom Grundkörper (1); **dadurch gekennzeichnet,** daß
- als Grundkörper ein Hohlzylinder (1) verwendet und
- dieser selbst über wenigstens eine seiner Stirnseiten durch ein Druckgas so stark aufgeblasen wird, daß er einen kreisrunden Querschnitt erhält.

2. Verfahren nach Anspruch 1, **dadurch gekennzeichnet,** daß Druckgas über beide Stirnseiten in den Grundkörper (1) eingeblasen wird.

3. Verfahren nach Anspruch 1 oder 2, **dadurch gekennzeichnet,** daß als Druckgas Luft verwendet wird.

4. Verfahren nach einem der Ansprüche 1 bis 3, **dadurch gekennzeichnet,** daß die lichtempfindliche Schicht (4; 4a, 4b) mittels eines Laserstrahls belichtet wird.

5. Verfahren nach Anspruch 4, **dadurch gekennzeichnet,** daß das Entfernen von Bereichen der lichtempfindlichen Schicht (4) durch Wegbrennen dieser Bereiche mittels Laserstrahlung erfolgt.

6. Verfahren nach Anspruch 5, **dadurch gekennzeichnet,** daß eine lichtempfindliche Schicht verwendet wird, die eine auf der Oberfläche des Grundkörpers (1) liegende Haftverstärkungsschicht und eine auf dieser Haftverstärkungsschicht liegende eingefärbte Schicht aufweist.

7. Verfahren nach Anspruch 4, **dadurch gekennzeichnet,** daß das Entfernen von Bereichen der lichtempfindlichen Schicht (4; 4a, 4b) dadurch erfolgt, daß sie durch Laserstrahlung polymerisiert und anschließend entwickelt wird.

8. Verfahren nach Anspruch 7, **dadurch gekennzeichnet,** daß eine lichtempfindliche Schicht verwendet wird, die wenigstens eine eingefärbte erste Harzschicht (4a) auf der Oberfläche des Grundkörpers (1) und eine zweite transparente und photosensibilisierte Harzschicht (4b) auf der ersten Harzschicht (4a) aufweist.

9. Verfahren nach Anspruch 8, **dadurch gekennzeichnet,** daß die erste Harzschicht (4a) photosensibilisiert ist, jedoch schwächer als die zweite Harzschicht.

10. Verfahren nach Anspruch 8 oder 9, **dadurch gekennzeichnet,** daß die erste Harzschicht (4a) eine Substanz enthält, durch die bei Belichtung freigesetzte Radikale abgefangen werden.

11. Verfahren nach einem erAnsprüche 4 bis 10, **dadurch gekennzeichnet,** daß die Belichtung der lichtempfindlichen Schicht (4; 4a, 4b) so erfolgt, daß spätere Sieböffnungen (16) unterschiedliche Abstände voneinander aufweisen.

12. Verfahren nach einem der Ansprüche 1 bis 11, **dadurch gekennzeichnet,** daß beim Auffüllen der entfernten Bereiche der lichtempfindlichen Schicht (4; 4a, 4b) mit Metall der Grundkörper (1) von innen verstärkt wird.

13. Verfahren nach Anspruch 12, **dadurch gekennzeichnet,** daß die Verstärkung durch Einbringen eines Schlauchs (41) in den Grundkörper (1) erfolgt, wobei der Schlauch (41) an der Innenwand des Grundkörpers (1) anliegt.

14. Verfahren nach Anspruch 13, **dadurch gekennzeichnet,** daß der Schlauch (41) aufgeblasen wird.

15. Verfahren nach einem der Ansprüche 1 bis 14, **dadurch gekennzeichnet,** daß als Metall Nickel aufgebracht wird.

16. Verfahren nach einem der Ansprüche 1 bis 15, **dadurch gekennzeichnet,** daß zum Abnehmen des Zylindersiebs vom Grundkörper (1) das Zylindersieb radial nach innen gedrückt wird.

## Claims

1. Method of producing a screen printing stencil, having the following steps:
- applying at least one light-sensitive layer (4; 4a, 4b) to an essentially closed covering surface of a cylindrical base body (1);
- removing portions of the light-sensitive layer (4; 4a, 4b) from the covering surface in accordance with a prescribed screen pattern;
- filling the portions thus removed of the light-sensitive layer (4; 4a, 4b) with metal for the purpose of forming a cylindrical screen (14); and
- removing the cylindrical screen from the base body (1);
characterized in that
- a hollow cylinder (1) is used as base body and
- this is itself inflated via at least one of its ends by a compressed gas to such an extent that it obtains a circular cross-section.

2. Method according to Claim 1, characterized in that compressed gas is blown into the base body (1) via both ends.

3. Method according to Claim 1 or 2, characterized in that air is used as compressed gas.

4. Method according to one of Claims 1 to 3, characterized in that the light-sensitive layer (4; 4a, 4b) is exposed by means of a laser beam.

5. Method according to Claim 4, characterized in that the removal of portions of the light-sensitive layer (4) is carried out by burning away these portions by means of laser radiation.

6. Method according to Claim 5, characterized in that a light-sensitive layer is used which has an adhesion reinforcing layer located on the surface of the base body (1) and a pigmented layer located on this adhesion reinforcing layer.

7. Method according to Claim 4, characterized in that the removal of portions of the light-sensitive layer (4; 4a, 4b) is carried out by said layer being polymerized by laser radiation and subsequently developed.

8. Method according to Claim 7, characterized in that a light-sensitive layer is used which has at least one pigmented first resin layer (4a) on the surface of the base body (1) and a second transparent and photosensitized resin layer (4b) on the first resin layer (4a).

9. Method according to Claim 8, characterized in that the first resin layer (4a) is photosensitized, but more weakly than the second resin layer.

10. Method according to Claim 8 or 9, characterized in that the first resin layer (4a) contains a substance by which radicals set free during exposure are intercepted.

11. Method according to one he [sic] Claims 4 to 10, characterized in that the exposure of the light-sensitive layer (4; 4a, 4b) is carried out in such a way that later screen openings (16) have different distances from one another.

12. Method according to one of Claims 1 to 11, characterized in that, when filling the removed portions of the light-sensitive layer (4; 4a, 4b) with metal, the base body (1) is reinforced from the inside.

13. Method according to Claim 12, characterized in that the reinforcement is carried out by introducing a tube (41) into the base body (1), the tube (41) resting on the inner wall of the base body (1).

14. Method according to Claim 13, characterized in that the tube (41) is inflated.

15. Method according to one of Claims 1 to 14, characterized in that nickel is applied as the metal.

16. Method according to one of Claims 1 to 15, characterized in that the cylindrical screen is pressed radially inwards to remove the cylindrical screen from the base body (1).

## Revendications

1. Procédé de fabrication d'un écran de sérigraphie, comprenant les étapes suivantes consistant :
- à appliquer au moins une couche sensible à la lumière (4 ; 4a, 4b) sur une surface d'enveloppe sensiblement fermée d'un corps de base cylindrique (1) ;
- a éliminer par zones la couche sensible à la lumière (4 ; 4a, 4b) de la surface d'enveloppe selon un modèle sérigraphique prédéterminé ;
- a remplir les zones ainsi éliminées de la couche sensible à la lumière (4 ; 4a, 4b) avec un métal dans le but de réaliser un écran cylindrique (14) ; et
- à évacuer l'écran cylindrique du corps de base (1) ;
caractérisé en ce que :
- on utilise comme corps de base un cylindre creux (1) ; et
- on gonfle ce cylindre creux lui-même à partir d'au moins l'une de ses surfaces frontales avec un gaz sous pression, de telle façon qu'il présente une section transversale circulaire.

2. Procédé selon la revendication 1, caractérisé en ce qu'on insuffle le gaz sous pression dans le corps de base (1) par les deux faces frontales.

3. Procédé selon la revendication 1 ou la revendication 2, caractérisé en ce que l'on utilise comme gaz sous pression de l'air.

4. Procédé selon l'une des revendications 1 à 3, caractérisé en ce qu'on expose la couche lumière (4 ; 4a, 4b) à l'aide d'un rayonnement laser.

5. Procédé selon la revendication 4, caractérisé en ce qu'on réalise l'élimination des zones de la couche (4) sensible à la lumière par brûlage destructeur de ces zones à l'aide d'un rayonnement laser.

6. Procédé selon la revendication 5, caractérisé en ce qu'on utilise une couche sensible à la lumière qui comporte une couche de renforcement de l'adhérence se trouvant sur la couche de base et une couche colorée se trouvant sur cette couche de renforcement de l'adhérence.

7. Procédé selon la revendication 4, caractérisé en ce que l'élimination des zones de la couche sensible à la lumière (4 ; 4a, 4b) est réalisée de telle façon qu'elles soient polymérisées par le rayonnement laser et ensuite développées.

8. Procédé selon la revendication 7, caractérisé en ce que l'on utilise une couche sensible à la lumière qui comporte au moins une première couche de résine (4a) colorée sur la surface du corps de base (1) et une deuxième couche de résine (4b) transparente et photosensibilisée sur la première couche de résine (4a).

9. Procédé selon la revendication 8, caractérisé en ce que la première couche de résine (4a) est photosensibilisée, tout en étant cependant plus mince que la deuxième couche de résine.

10. Procédé selon la revendication 8 ou 9, caractérisé en ce que la première couche de résine (4a) comporte une substance par l'intermédiaire de laquelle les radicaux libérés par l'éclairage sont récupérés.

11. Procédé selon l'une des revendications 4 à 10, caractérisé en ce que l'éclairage de la couche sensible à la lumière (4 ; 4a, 4b) est réalisé de telle façon que les ouvertures ultérieures (16) de l'écran présentent des écartements différents les unes par rapport aux autres.

12. Procédé selon l'une des revendications 1 à 11, caractérisé en ce que, au cours du remplissage par du métal des zones éliminées ou évacuées de la couche sensible à la lumière (4 ; 4a, 4b), on renforce de l'intérieur le corps de base (1).

13. Procédé selon la revendication 12, caractérisé en ce que le renforcement est réalisé par mise en place d'un tube flexible (41) dans le corps de base (1), le tube flexible (41) étant disposé sur la paroi intérieure du corps de base.

14. Procédé selon la revendication 13, caractérisé en ce que l'on gonfle le tube flexible (41).

15. Procédé selon l'une des revendications 1 à 14, caractérisé en ce qu'on applique comme métal du nickel.

16. Procédé selon l'une des revendications 1 à 15, caractérisé en ce que, pour déposer l'écran cylindrique du corps de base (11), on presse l'écran cylindrique radialement vers l'intérieur.
